# NEW EUROPEAN PATENT SPECIFICATION

(11) **EP 0 391 418 B2**
(45) Date of publication and mention of the opposition decision: **09.09.1998**
(45) Mention of the grant of the patent: 25.01.1995
(21) Application number: 90106545.8
(22) Date of filing: 05.04.1990
(51) Int. Cl.: C30B 33/00, C30B 21/04, B28D 5/00

(54) **A diamond for a dresser**
Diamant für Abrichtungsvorrichtung
Diamant pour dispositif à dresser

(30) Priority: 06.04.1989 JP 88517/89; 25.10.1989 JP 277393/89
(43) Date of publication of application: 10.10.1990
(73) Proprietor: SUMITOMO ELECTRIC INDUSTRIES, LTD., Osaka-shi, Osaka 541 (JP)
(72) Inventor: Satoh, Shuichi, c/o Itami Works, Itami-shi, Hyogo (JP); Tsuji, Kazuwo, c/o Itami Works, Itami-shi, Hyogo (JP); Yoshida, Akito, c/o Itami Works, Itami-shi, Hyogo (JP); Urakawa, Nobuo, c/o Itami Works, Itami-shi, Hyogo (JP)
(74) Representative: Hansen, Bernd, Dr. Dipl.-Chem.

(56) References cited:
- EP-A- 0 136 408
- JP-A-59 229 227
- US-A- 4 122 636
- US-A- 4 401 876
- WIRE INDUSTRY, vol. 53, no. 10, October 1986, pages 696-704, Oxted, Surrey, GB; K.G. EDER: "Wire drawing dies and die working equipment"
- WIRE INDUSTRY, vol. 56, no. 7, July 1989, pages 388-393, Oxted, Surrey, GB; SUMITOMO ELECTRIC INDUSTRIES LTD et al.: "Diamond dies - mined or manufactured?"
- B.K. Royer, "What's new in wire dies", Wire Technology, May 1989, pages 14 and 15
- S. Yazu, "Synthetic Diamond Heat Sinks", New Diamond, No.1, March 1988, pages 62 and 63
- S. Ramaseshan, "The cleavage properties of diamond", Proc. Indian Acad. Sci. A, 1946, No.1, pages 114-121
- A.R. Patel and K.N. Goswami, "Optical and interferometric studies on the cleavages of synthetic diamonds and their etch patterns", Brit. J. Appl. Phys., Vol. 14, 1963, pages 284-286

## Description

The present invention relates to a synthetic single crystal diamond for a dresser. EP-A-0136408 a publication of the present applicant, discloses the use of type lb diamond containing from to 5 to 100 ppm nitrogen as a wire drawing die.

Diamond has the highest hardness and modulus of elasticity of any existing material. Furthermore, extremely pure diamond also has the highest thermal conductivity and highest transmittance of infrared light. Thus, diamond is one of the precious resources that cannot be replaced by other materials.

There are generally two types or methods for synthesizing diamond using high temperature and high pressure. In one such method, carbon material is mixed or brought into contact with a solvent metal such as iron, cobalt or nickel to be subjectd to diamond. A stable high pressure and temperature whereby the carbon is converted into diamond under the action of the solvent metal is used. According to such a method, the solvent metal into the carbon material, whereby the carbon is caused to diffuse through the solvent metal which is in the form of a thin film, to generate diamond. According to this method, a diamond is spontaneously nucleated, and rapidly grows until it reaches a certain size. A considerable quantity of fine diamond powder has generally been synthesized by this method to be applied to, e.g. abrasives. However, large diamond crystals of high quality cannot be synthesized by the aforementioned method.

On the other hand, a method of synthesizing large diamond crystals of good quality is disclosed in U.S. Patent No. 3,297,407. Furhermore U.S. Patent No. 4,632,817 provides a diamond synthesizing temperature gradient method which can synthesize a number of large diamond crystals of high quality simultaneously from a plurality of seed crystals.

The present invention is applicable to diamond synthesized by the temperature gradient method.

Most diamond crystal dies are made of natural diamond, whose (110) or (111) faces are polished and then at least one vertical face to said faces is also polished for obervation of the formation of a hole in the diamond. After the preparations, a wire drawing hole which is vertical to (110) or (111) faces is formed by a laser beam, electric discharge or ultrasonic grinding, while observing through the polished face. Synthetic diamond crystals are put on the market and various efforts to apply them for wire drawing are carried out.

However, the life of tools made according to the prior art displayed a wide range and a lack of reliability. Especially, the life of tools made of natural single crystal diamonds is widely distributed.

The faults of a natural diamond crystal wire drawing die include the following. It is said that a die having a wire drawing hole vertical to the (110) face has generally the highest wear resistance and the longest life. See Junkatsu (Lubrication), vol 112, No. 11, 1967. However, the tool life of such dies is variable, for the following reasons.

First, because natural diamonds are rounded, and have a variety of shapes (depending upon the degree of dissolution), it is difficult to judge precisely where the (110) face is. As a result, it requires considerable skill to determine the (110) faces of a natural diamond used as wire drawing dies. Therefore, most of the wire drawing hole directions are not as intended, which shortens tool life.

Second, natural diamonds often have a soft portion and hard portion in one single crystal. The wire drawing hole wears during drawing and deforms from a complete circle to a distorted one. This is another cause of reduced tool life.

Recently, high qualitive synthetic diamond has been obtained by the temperature gradient method and is on the market. In spite of the many attempts to use synthetic diamond for a wire drawing die, a high quality wire drawing die has not been obtained yet and the reasons are the following.

First, synthesized or slightly polished idiomorphic diamond is generally used for wire drawing dies. In order to hold such a diamond to a tool holder, a hexahedron diamond is suitable. This is mainly covered with (100) faces, and the wire drawing holes are thus vertical to the (100) faces. However, a drawing hole of such direction has inferior wear resistance and a short tool life.

Secondly, some synthetic diamonds lack uniform concentration of nitrogen. This can cause uneven wear of the drawing hole.

Thirdly, holding the diamond to a tool holder using the surfaces of grown diamond or polished surfaces requires a large stress to hold the diamond in place, because of the very low friction coefficient between the diamond surfaces and the holder. Therefore, the wire drawing die often cracks during drawing.

Concerning the dividing diamond method, cutting and cleavage are well known. In the former method, there are two ways; one of which is represented by the following. A cutting blade in which diamond particles are embedded rotates at high speed, presses forward on the diamond and performs the cutting. The other is thermal cutting, for example, using a laser beam. See, for example, US-A-4401876 for a proposal to form a groove in a gemstone diamond, using a laser.

Concerning the latter method, a diamond is grooved by the other diamond or a cutting blade and then a knife-shaped wedge is struck into the groove thereby to cleave the diamond, as shown on pages 411-412 of Kesshokogaku Handbook. The latter is thought to be the best method to divide a diamond economically, taking advantage of diamond's propensity to be easily cleaved parallel to the (111) faces. The method does not require a width loss equal to the cutting blade, especially when compared to the former method and also does not require a great deal of time to divide.

However, only commercial diamond cutters use this method to divide large diamonds for ornaments. According to this method, it requires a high level of skill, and the attendant risk of destroying a high priced diamond is great. The probability of an uneven divided plane is high, as shown in Diamond (Sanyo Shuppan Boueki Ltd.,) pages 216-218 and "Ceramics" 11 (1976) No. 6 page 520, the method is not used in industrial fields. In addition, it has until now been impossible to divide a diamond to get plural, thin and uniform plates which are indispensable for heat-sink and wire drawing dies.

The researches of the Applicant have made certain things clear. To obtain an even cleavage plane, the angle between the groove and the cleavage plane (111) faces must be at most 0.5°. However, using another diamond or a cutting blade it is impossible to groove with such accuracy because a diamond is hard enough to get such an accuracy of 0.5°. Also, for successful cleavage, the linearity of the groove has to be within 0.1 mm, but it is very difficult using the prior art to achieve such accuracy.

An object of the present invention is to provide a diamond for a dresser made of a synthetic single crystal diamond.

According to the present invention, there is provided a diamond as claimed in claim 1 below. Disclosed below is process for manufacturing a diamond for wire drawing die which involves a groove on a single crystal diamond, which groove is parallel to the (111) faces and is made by an energy beam selected from an electron beam, an ion beam and laser beam, and then a wedge is struck into the groove to divide the single crystal diamond.

In the accompanying drawings:

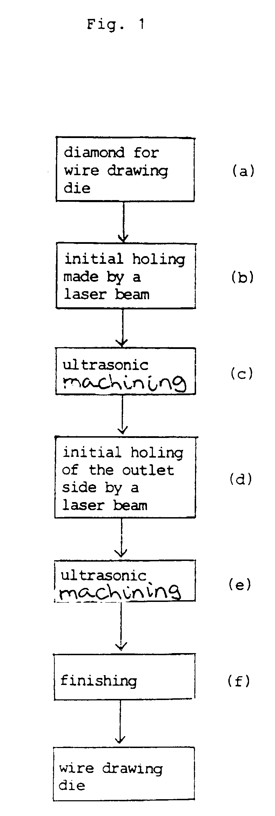

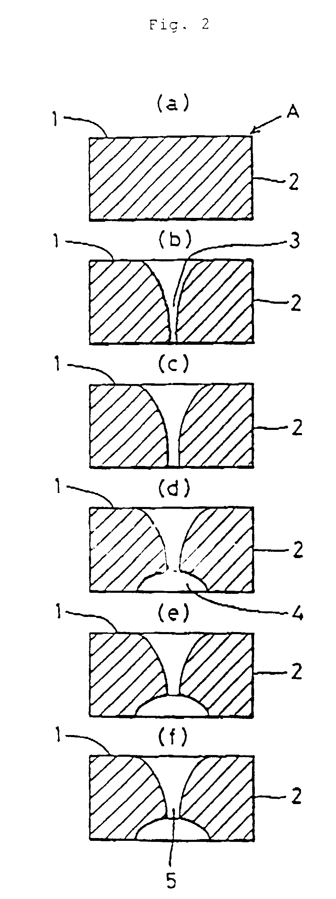

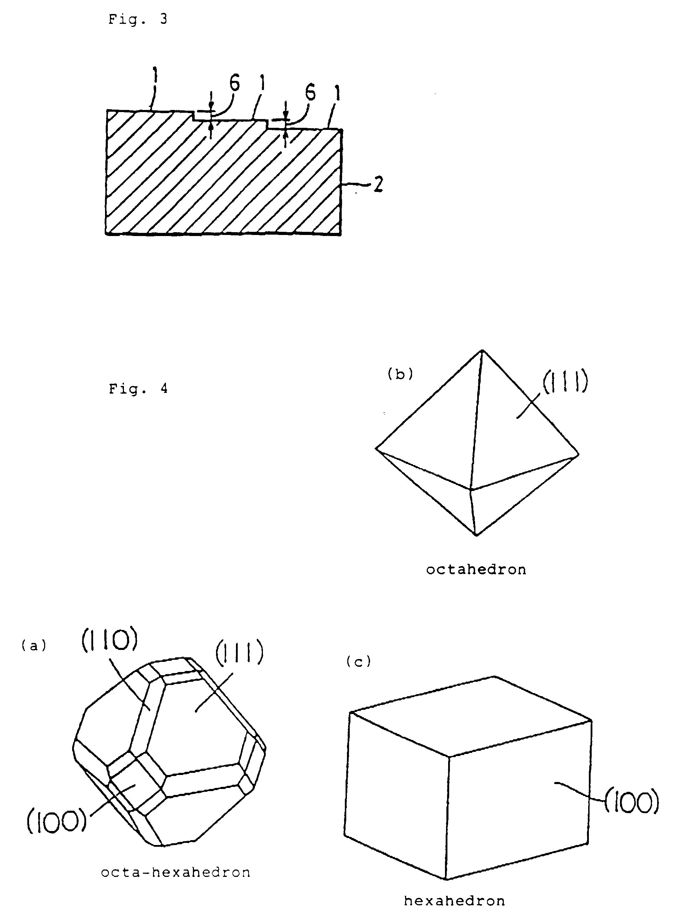

Fig. 1 is a schematic diagram of the process to make a wire drawing die; Fig. 2 is a cross sectional view, showing a wire drawing hole in each step of Fig. 1; Fig. 3 is a cross sectional view of the cleavage plane; Fig. 4 shows typical single crystal diamonds; Fig. 4(a) is an octa-hexahedron; Fig. 4(b) is an octahedron; and Fig. 4(c) is a hexahedron.

This invention relates to a synthetic single crystal diamond of an lb type which contains nitrogen between 20 - 400 ppm and synthesized as by the temperature gradient method. Generally, the nitrogen in the synthetic single crystal diamond of an lb type is isolated and distributed. There is a tendency in the lb type synthetic single crystal diamond that the larger the concentration of the nitrogen, the smaller is the wear during drawing. However, when the concentration of the nitrogen exceeds 400 ppm, the wear increases. On the other hand, when the concentration of the nitrogen is below 20 ppm, the diamond only partially wears. These relationships between the concentration of nitrogen and wear were found. This invention provides an excellent synthetic diamond for wire drawing die which shows little wear and wears uniformly depending on the concentration of nitrogen, between 20 to 400 ppm.

Therefore, when the concentration of the nitrogen is out of this range, the wire drawing hole wears unevenly because of the difference of the concentration of nitrogen. Then the wire drawing hole is transformed to an irregular shape useless for wire drawing. Or the wire drawing hole becomes enlarged rapidly, and a short tool life is the result.

This specification discloses a wire drawing die whose drawing direction is parallel to the 〈111〉 direction and whoses hole is built precisely vertical to the (111) faces using a cleavage plane (111) as a standard plane to minimize the discrepancy from the 〈111〉 direction. The present inventors found that the wear resistance of synthetic single crystal diamond is not so dependent upon the face index as a natural diamond. Concerning the synthetic single crystal diamond, the wear of the 〈100〉 direction is great, but the wear of the 〈111〉 and 〈110〉 directions, was less than the 100 direction and nearly the same as each other. Generally, the wear resistance of natural diamond strongly depends on the direction of the crystal, and the wear of the 〈111〉 direction is less than the 〈110〉 direction.

It is found that the wear resistance of the wire drawing hole depends strongly on the discrepancy of the angle between the center line of the drawing hole and the 〈111〉 direction. In order to minimize this discrepancy, it has been found to be quite useful that, as the (111) faces are vertical to the 〈111〉 direction, the cleavage plane of the (111) faces can be used as the standard plane and the wire drawing hole can be made precisely vertical to the cleavage plane.

A diamond synthesized by the temperature gradient method is mostly idiomorphic. Therefore it is precise and easy to discriminate the plane index, and also it is easy to cleave the (111) faces of the desired size of an idiomorphic single crystal diamond. In addition, it is found that the cleavage plane of the synthetic diamond is smooth and even. In many cases, the cleavage planes of natural diamonds have cleavage bandings, many large steps and spiral steps. Furthermore, other (111) faces appear, having different directions.

In making the wire drawing hole vertical to the (111) faces, it is important that the surface roughness of the standard cleavage plane (111) is at most 100 µm. Referring to Fig. 3, the surface roughness is equal to the height of a step 6 between two cleavage plane 1. A plane 2, cut by a laser beam, is shown. To estimate the cleavage plane, the height and the number of steps are important factors, and the preferable embodiment is a 30 - 100 µm height and also at most 3 steps of 1 mm lengths.

When the number of 1 mm long steps is larger than 4, it is impossible to define precisely the 〈111〉 direction. Therefore it is difficult to make the drawing hole exactly in the 〈111〉 direction.

In order to hold the drawing die tightly to the tool holder, at least one side is roughened by cutting thermally, for example, using a laser beam, to increase the friction coefficient.

The surface of a grown synthetic diamond is smoother than the surface of natural diamond, and much stress is indispensable to hold the wire drawing die to the tool holder using the rough surfaces. When holding on a polished surface, a large stress is also necessary. Such large stress causes cracking of the die during drawing.

We provide a solution to lower the compressive stress, because at least one side is a rough surface made by an energy beam cutting such as a laser beam, an ion beam or an electron beam. The preferable surface roughness is between 5 to 100 µm. When the surface roughness is less than 5 µm, a large compressive stress to hold the die to the tool holder is unavoidable due to a small friction coefficient. On the other hand, when the surface roughness is more than 100 µm, a stress concentration occurs on the uneven surface and this causes the initiation of cracking.

We can provide a wire drawing die having an angle within 3° between the center line of the wire drawing hole and the 〈111〉 direction of the diamond. The discrepancy in the angle between the 〈111〉 direction and the center line of the wire drawing hole is one of the most important factors for wear resistance during drawing. The larger the discrepancy, the less the wear resistance of the wire drawing hole.

We also provide an improved wire drawing die which has the characteristics of long tool life with a narrowed range when the angle discrepancy between the cleavage plane of the (111) faces and the center line of the drawing hole is between 89° to 91°. The cleavage of a single diamond is necessary for this invention.

A (111) plane of synthetic single crystal rough diamond may be used as the standard plane for making the wire drawing hole to lower the angle discrepancy. However this method is inferior in that the shape of the wire drawing die becomes close to the shape of a single diamond and whose shape is not easily controlled. Also, a single diamond having a large (111) plane area must be selected.

We also provide a method to produce the wire drawing die having a long tool life. This method involves the next two processes.

The first is that a surface of a single crystal diamond is grooved parallel to the (111) faces by the use of an ion beam, an electron beam or a laser beam. Using an X-Y table having a moving apparatus, the (111) faces of the single crystal diamond are adjusted parallel to the X or Y axis of the table and also parallel to the energy beam and then the single crystal diamond is easily grooved. This process if preferred as an effective means for the next cleavage process, in order to cleave reliably and precisely without the considerable skill required in the prior art techniques. After grooving on the surface of the single crystal diamond, a sharp plate such as a wedge or a knife made of metal or ceramics is set into the groove and the sharp plate is forced into the groove parallel to the (111) faces and then the single crystal diamond is divided completely. Hammering, pressing, or the stress of thermal expansion can be used as a means to force the sharp plate into the groove.

Generally, the length of the wedge is longer than that of the groove, however, there is no limit to the length of the wedge. Specifically, the length of the knife should be shorter than the groove. Furthermore, a needle is occasionally used as a wedge. This improved process represents an improvement in ease, reliability and precision to divide a diamond, compared to the prior art. The method using a laser beam has been said to be the most reliable and precise method to divide a single crystal diamond. Since the groove becomes V shaped, when the energy beam is used, good results are obtained.

A large and a good quality synthetic single crystal diamond is more preferable than a natural single crystal diamond, because it is reliable, easy and precise to divide a single crystal diamond. As aforementioned, most natural single crystal diamonds were dissolved in the earth, with surfaces which are curved or uneven, and therefore it is difficult to identify the (111) faces from the external appearance, whose faces are indispensable for cleavage of single crystal diamond. There is a method however to discriminate a plane index using X ray. But this method takes much time and many steps, so that it is said that this method is not efficient from an economical view point. On the other hand, the synthetic single crystal diamond is generally polyhedron surrounded by the (111) faces and the (100) faces as shown in Fig. 4, therefore it is easy to distinguish the (111) faces from the external appearance, and it is also preferable to use synthetic single crystal diamonds for this invention. When the single crystal diamond is set on the X-Y table to groove, it is easy to adjust the single crystal diamond within an accuracy of 0.1° between the (111) faces and the grooving direction. Thus, the growth plane (111) of the diamond is only fixed to the standard plane, which is parallel to the moving direction on the X-Y table.

In addition, a synthetic single crystal diamond which is larger than 1.5 mm in diameter, larger than 1/30 carat size and of high quality, is superior to a synthetic crystal diamond which is generally called an abrasive in the market and smaller than 1 mm in diameter. The abrasive is too small to handle and the quality is not sufficient for use as a wire drawing die.

These processes certify the linearity of the groove within 0.1 mm and the discrepancy of an angle between the (111) faces of the diamond and the cleavage plane (111) within 0.5°. Therefore, the cleavage plane (111) can be used as the standard plane to build the wire drawing hole.

When the wire drawing hole become enlarged from normal wear and erosion, the hole can be reshaped for drawing larger wire.

### TRIAL 1

Five lb type single crystal diamonds, which contained 10 - 500 ppm of nitrogen and were of 0.4 - 0.6 carat size, were synthesized under a pressure of 5.5 GPa and a temperature of between 1300°C to 1400°C, employing the temperature gradient method and various solvent metals. These synthetic single crystal diamonds had cleaved (111) faces, and a 1.5 mm thick plate was obtained. And then the plates mere cut into a hexahedron of 2 mm x 2 mm x 1.5 mm using a laser beam. Furthermore, a cut side using a laser beam was polished and a diamond for wire drawing die was obtained. The polished surface was the (110) face. The height of the step on the cleavage plane was 60 µm. The three surface roughness of the sides cut by the laser beam were 40 µm.

Each diamond was worked into a wire drawing die, following the process of Fig. 1, Fig. 2 shows the shape of the wire drawing hole corresponding to Fig. 1. A diamond for wire drawing die A in Fig. 2 (a) (1 is cleavage plane, 2 is the cut side by laser) had an initial hole 3 made by the laser bean as shown in Fig. 2 (b), and then the surface of the initial hole was polished smooth by ultrasonic machining as shown in Fig. 2 (c). The opposite side of diamond. A had an initial hole 4 made by the laser beam as shown in Fig. 2 (d), and then the surface of the initial hole was also polished smooth by ultrasonic machining as shown in Fig. 2 (e). Lastly, a wire passed through the wire drawing hole 5 to provide a finish and the wire drawing die was obtained as shown in Fig. 2 (f). The diameter of the wire drawing hole was 40 µm determined by measuring the diameter of the wire. Each wire drawing die was settled in a holder and employed for copper drawing.

The results are shown in Table 1.

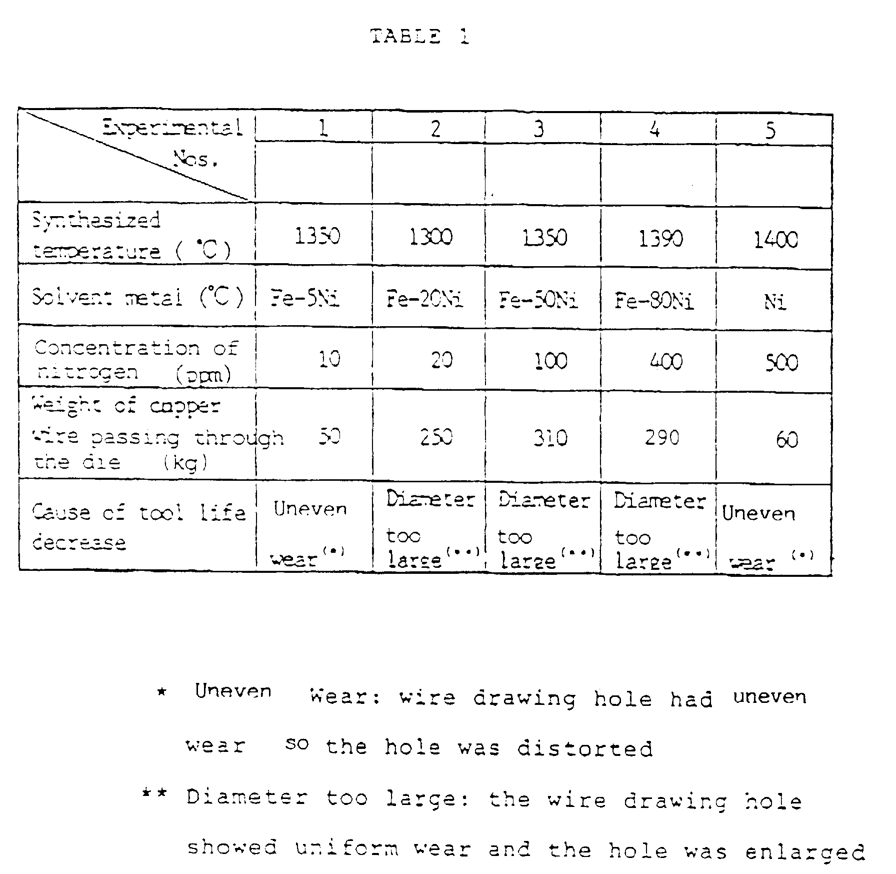

Table 1 shows that the wire drawing dies which contain nitrogen between 20 to 400 ppm, have excellent properties .

### TRIAL 2

Six single crystal diamonds which were of a 0.3 carat size were synthesized unde a pressure of 5.5 GPa and a temperature of 1350°C, employing the temperature gradient method and Fe-50 Ni as the solvent metal. Three wire drawing dies whose sizes were 1.4 mm x 1.4 mm x 1.1 mm, had 30 µm diameter wire drawing holes, and were obtained in the same process as Example 1. The surface of 1.4 mm x 1.4 mm were cleavage planes, and had a wire drawing hole directed to the thickness direction of 1.1 mm.

The other three diamonds were polished substituted for cleavage into plates of 1.1 mm thickness. Then, the diamonds were worked into the wire drawing die which had 30 µm diameter wire drawing holes and a size of 1.4 mm x 1.4 mm x 1.1 mm using the same process as Example 1. The wire drawing holes were vertical to the surfaces of 1.4 mm x 1.4 mm. The concentration of nitrogen in the diamond was between 80 to 100 ppm. This concentration was estimated from the infra-red absorption coefficient at 1130 cm⁻¹. The height of the steps on the cleavage plane was between 50 to 60 µm. The surface roughness of the cut side by laser beam was between 25 to 30 µm. The surface roughness of the polished side was 0.1 µm. After measuring the angle between the center line of the wire drawing hole and the cleavage plane or polished plane using an X-ray apparatus for measuring the direction of crystal, the wire drawing dies were employed for copper wire drawing. Table 2 shows the results. All of the wire drawing holes became enlarged, and their tool life shortened.

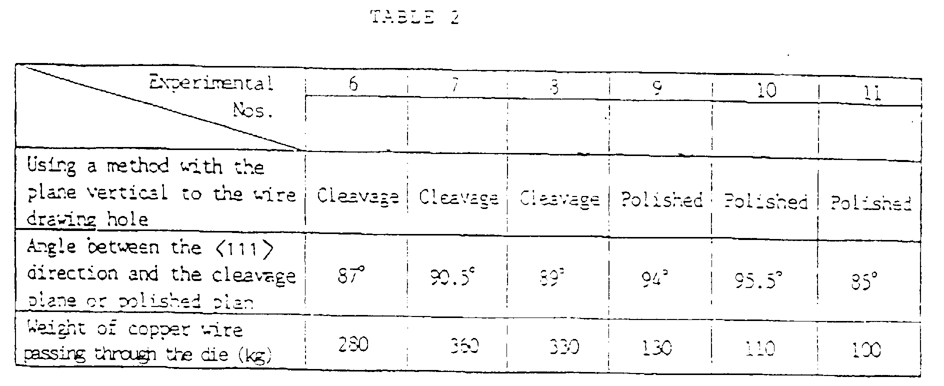

Table 2 shows that the wire drawing dies having a cleavage plane as (111) faces is preferable to having a polished plane, and the wire drawing dies having an angle between 87 - 90° were preferred embodiments, and the angle between 89 - 90° were the best embodiments.

### TRAIL 3

A single crystal diamond of 0.8 carat size, was synthesized under a pressure of 5.5 GPa and a temperature of 1350°C, employing the temperature gradient method and Fe-50 Ni as the solvent metal, and then the single crystal diamond was cleaved into two plates each 0.6 mm thick. Two wire drawing dies were made from each plate by the same process as example 1 and the sizes were 1 mm x 1 mm x 0.6 mm. The diameter of drawing wire was 30 µm.

In addition, two natural diamonds were purchased, and cleaved using a diamond face which seemed to be similar to a (111) face, and two plates having a 0.6 mm thickness were obtained, and then two wire drawing dies were made in the same process as example 1. The size of dies were 1 mm x 1 mm x 0.6 mm. The concentration of nitrogen in the synthetic diamond was 90 ppm. The concentration of nitrogen in the natural diamonds were 1250 ppm and 2000 ppm.

Table 3 shows the results.

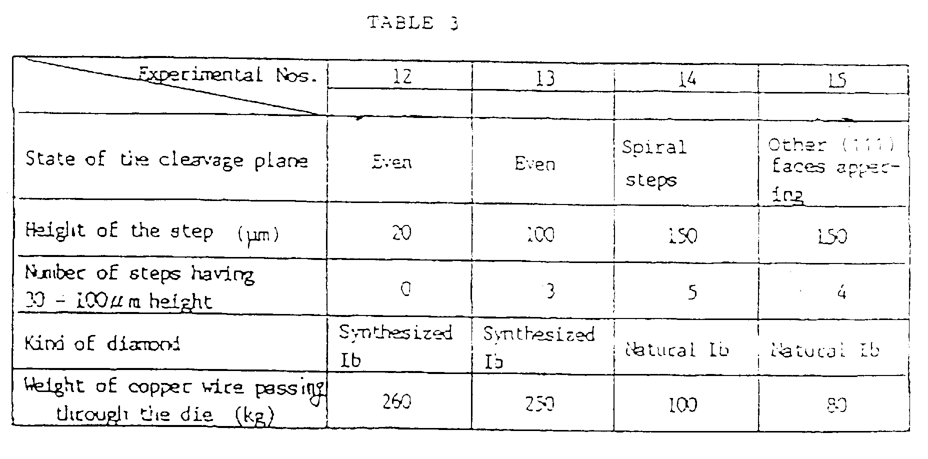

The wire drawing dies which had a step height below 100 µm had an advantage over the others.

### TRIAL 4

Five single crystal diamonds of 0.5 - 0.6 carat size, were synthesized under a pressure of 5.3 GPa at a temperature of 1300°C employing Fe-30 Ni as the solvent metal. The concentration of nitrogen was between 40 - 500 ppm. Five drawing dies of 2 mm x 2 mm x 1.5 mm were made in the same process as Example 1. In one of them, all the sides cut by laser were polished. The sides of the other four were cut using various laser beam conditions to provide various surface roughness, and then, one side of each drawing die cut by a laser beam was polished. The polished surfaces were the (110) faces and (112) faces. These wire drawings were fixed to the holder, and wire drawing testing was carried out. Table 4 shows the results.

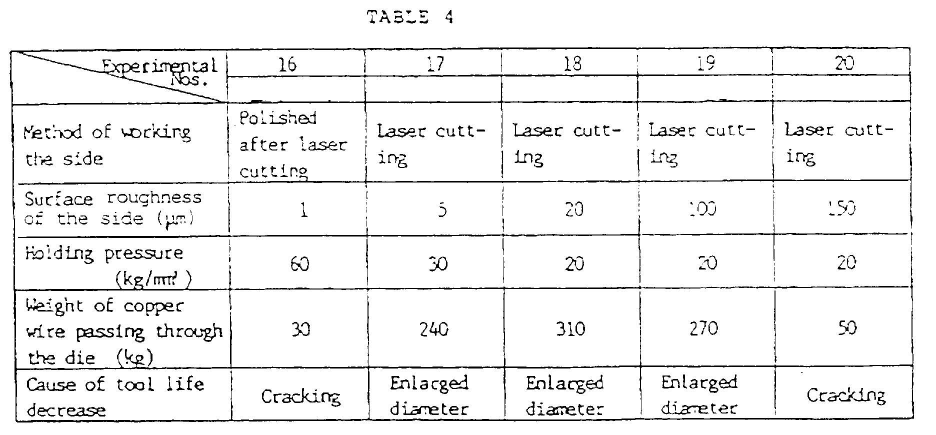

Table 4 shows that the diamonds whose surface texture was between 5 to 100 µm, provided better results.

### TRIAL 5 (The diamonds used in this example do not form part of the invention)

Seventy natural diamonds, which were of a 1.0 - 1.1 carat size of a octahedron like roundness, and did not contain impurities except for trace amounts of nitrogen, were divided into seven sets and each set consisted of 10 natural diamonds. Ten synthetic diamonds, which were also of a 1.0 - 1.1 carat size in a hexa-octahedron as in Fig. 4 (a) and did not contain impurities except for trace amounts of nitrogen, were prepared. These eighty diamonds were provided for the following cutting tests, and Table 5 shows the results. All the diamonds were cut in two using the four prior art methods and the four methods of our present disclosure. The ratio of those suffering no destruction using cleavage is shown in Table 5.

### The four methods of the prior art

### Experiment No. 21: Cutting by Blade

A disk of 0.15 mm thickness made of phosphor bronze was inserted in the cutting machine and a kneaded mixture of about 10 µm diamond powder with machine oil was rubbed on the circumference of the blade. The blade was rotated at 8,000 r p.m and then the blade ground the surface of a natural diamond, and the diamond was cut. Marks of the blade were revealed on the cut surface and also the cut surface had a curve of more than 0.1 mm.

### Experimental No 22: Cutting by Laser Beam

A natural diamond was set on a X-Y table, and then cut by a YAG laser bean of 20 watts, moving the table in a prescribed direction. There were many vertical stripes on the cut side due to the pulse laser. Furthermore the cut side had an inclination of 2 - 6° to the laser beam, and was not parallel to the vertical direction of the table. The inclination around the inlet portion of the laser beam differed from the inclination around the outlet portion, therefore the cut side was curved.

### Experiment No. 23: Cleavage After Being Flawed by a Diamond

After flawing a surface of natural diamond using another sharpened diamond, a steel wedge which had lead angle of 20° was wedged into the flaw by a hammer. As a result a great many of the natural diamonds were destroyed and the yield was as low as 30%. In addition, the cleavage planes of diamonds which wore not destroyed, were curved and shaped like a shell.

### Experiment No. 24:

After grooving the natural diamond employing the blade used in experiment No. 21, the diamond was cleaved by the same method as Experiment No. 23. The cleavage planes were rather improved over No. 23.

### The four methods of this disclosure

### Experimental No. 25:

The natural diamond was set on the X-Y table with the (111) faces parallel to the Y axis: a surface of the natural diamond was grooved by a YAG laser beam of 5 watts and the X-Y table moved toward the Y axis. The groove had a 0.08 mm width at the inlet of the laser beam, 0.3 mm depth and has V-shaped. A steel wedge having a lead angle of 20° was wedged into the groove by a hammer, and the natural diamond was cleaved.

The cleavage plane was more flat than the plane obtained by experimetal Nos. 23 and 24.

### Experiment No. 26:

The natural diamond was set on an X-Y table in the same way as experimental No. 25 whose table was settled in a vacuum chamber, and then the pressure of the vacuum chamber was lowered to 0.013 Pa (10⁻⁴ torr). An electron beam grooved the surface of the natural diamond, and the groove had a 0.1 mm which at the inlet of the laser beam, a 0.25 mm depth and was V-shaped. Furthermore, the natural diamond was cleaved in the same way as No. 25.

### Experiment No. 27:

An Ar ion beam was substituted for the electron beam used in experiment No. 26: the other processes were the same as for No. 26.

### Experiment No. 28:

A synthetic diamond of a 1.0 carat size having a hexa-octahedron shape was put in the place of a natural diamond as in experiment No. 25. The other processes were the same as for No. 25.

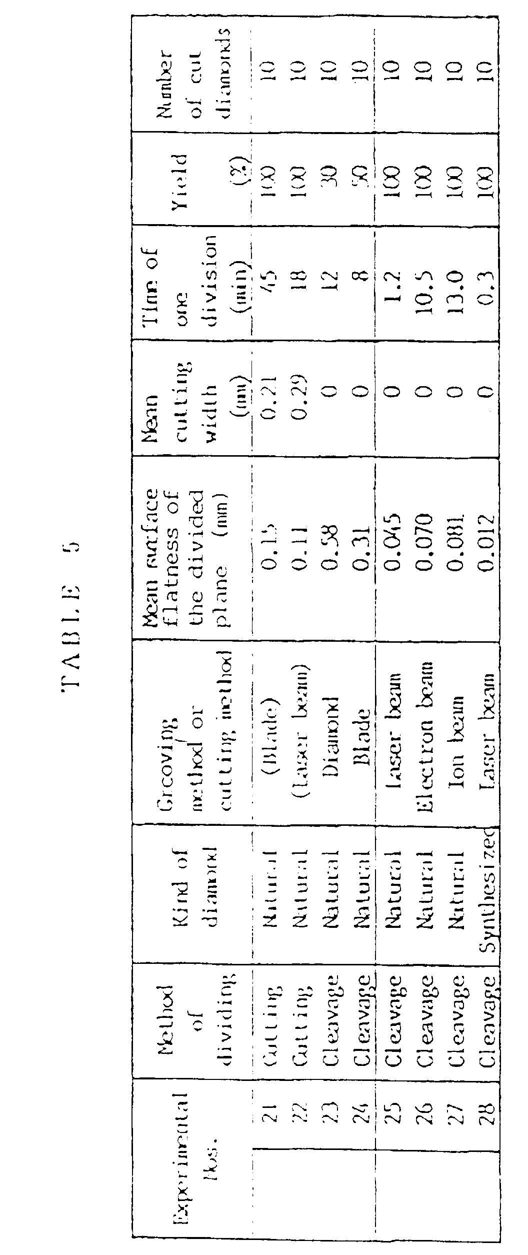

### TRIAL 6 (Except for the diamond dressers, the diamonds used in this trial do not form part of the invention).

Employing the same method as Example 5, each set consisted of ten (10) diamonds of 1.0 - 1.1 carat size and the diamonds were divided into 0.5 mm thick plates. The results are shown in Table 6.

Experiment No. 31 in table 6 shows that the objective of a plate of a 0.5 mm thickness could not be obtained using the process of Experiment No. 23.

All the dividing conditions were the same as Example 5.

The plates manufactured by the previously described method were made into the following products:

### (1) Wire drawing dies

The plates were cut by laser into rectangular shapes. Then the rectangular pieces were holed and polished to be made into wire drawing dies.

### (2) Dressers (in accordance with the present invention)

The plates were cut by laser into stick-like shapes. Then several pieces were mounted into steel shanks and finished as dressers.

### (3) Heat-sinks

The top and bottom faces of the plates were polished and cut by laser into rectangular shapes. Next the surfaces were metalized. Then the heat-sinks were finished.

All products were produced at a lower cost than previous methods. Furthermore the wire drawing dies and dressers demonstrated high and stable performance in abrasive tests.

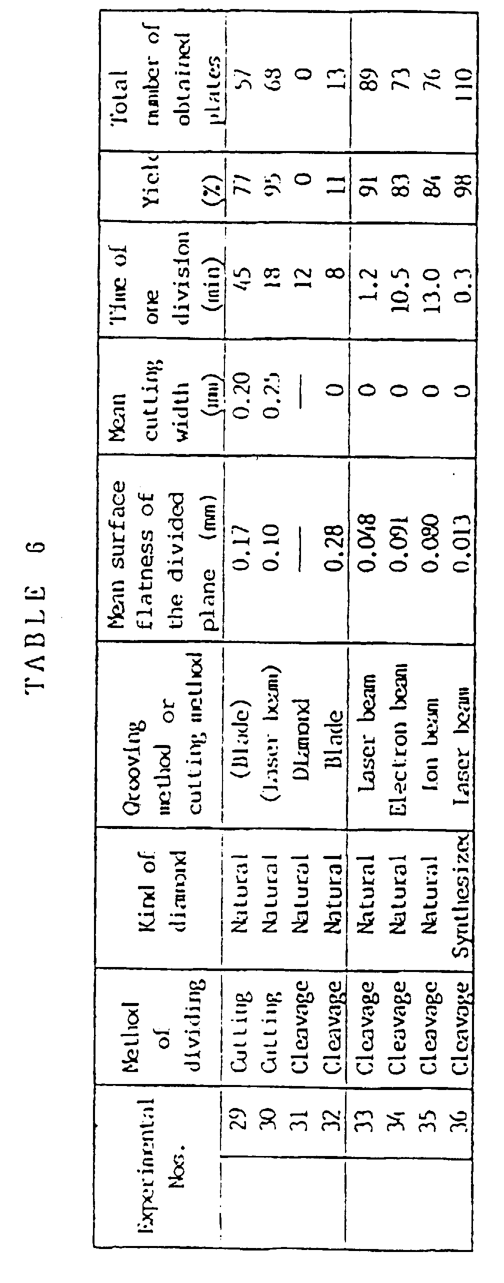

## Claims

1. A diamond for a dresser or a heat-sink, comprising a diamond containing 20 to 400 ppm nitrogen, said diamond being an lb type synthetic single crystal diamond with at least one of two faces of said diamond being formed by cleavage parallel to a (111) plane, and then cut by laser into a stick-like shape.

## Patentansprüche

1. Diamant für eine Abrichtungsvorrichtung, der einen Diamant mit einem Stickstoffgehalt von 20 bis 400 ppm umfaßt, wobei der genannte Diamant ein synthetischer Einkristalldiamant vom Typ Ib ist; und zumindest eine von zwei Flächen des genannten Diamanten durch Spaltung parallel zu einer (111)-Ebene ausgebildet und dann durch einen Laser in eine stabartige Form geschnitten wird.

## Revendications

1. Diamant pour outil à dresser, comprenant un diamant contenant de 20 à 400 ppm d'azote, ledit diamant étant un diamant monocristallin synthétique du type Ib avec au moins une des deux faces dudit diamant formée par clivage parallèle à un plan (111) et ensuite coupée par laser en une forme de type bâton.
